(19) **Europäisches Patentamt / European Patent Office / Office européen des brevets**

(11) **EP 1 719 248 B1**

(12) **FASCICULE DE BREVET EUROPEEN**

(45) Date de publication et mention
de la délivrance du brevet:
**06.08.2008 Bulletin 2008/32**

(21) Numéro de dépôt: **05717697.6**

(22) Date de dépôt: **31.01.2005**

(51) Int Cl.:
**H03K 3/84** $^{(2006.01)}$

(86) Numéro de dépôt international:
**PCT/FR2005/050058**

(87) Numéro de publication internationale:
**WO 2005/078926 (25.08.2005 Gazette 2005/34)**

(54) **GENERATION D UN FLUX DE BITS ALEATOIRE A HAUT DEBIT**

HOCHRATIGE ZUFALLS-BITSTROM-ERZEUGUNG

HIGH-RATE RANDOM BITSTREAM GENERATION

(84) Etats contractants désignés:
**AT BE BG CH CY CZ DE DK EE ES FI FR GB GR HU IE IS IT LI LT LU MC NL PL PT RO SE SI SK TR**

(30) Priorité: **30.01.2004 FR 0450170**

(43) Date de publication de la demande:
**08.11.2006 Bulletin 2006/45**

(73) Titulaire: **CENTRE NATIONAL DE LA RECHERCHE SCIENTIFIQUE (CNRS)**
**75794 Paris Cedex 16 (FR)**

(72) Inventeur: **AUBIN, Guy Georges**
**F-78220 Viroflay (FR)**

(74) Mandataire: **de Beaumont, Michel**
**Cabinet Beaumont**
**1, rue Champollion**
**38000 Grenoble (FR)**

(56) Documents cités:
**WO-A-01/37441          US-A- 3 657 718**
**US-A- 4 545 024          US-A- 5 153 532**

EP 1 719 248 B1

## Description

La présente invention concerne la génération aléatoire d'un flux de bits. L'invention concerne plus particulièrement la génération d'un flux à haut débit (supérieur à 10 gigabits/s) et s'applique plus particulièrement aux transmissions à haut débit sur des liaisons ou réseaux de communication quelconques.

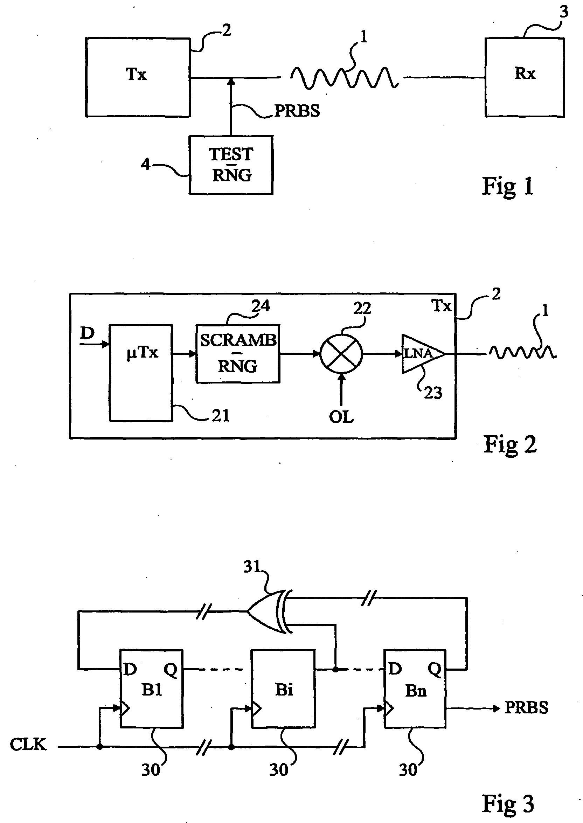

La figure 1 illustre, de façon très schématique et sous forme de blocs, un premier exemple d'application de la présente invention. Il s'agit d'un test d'une liaison 1 de communication entre un émetteur 2 (Tx) et un récepteur 3 (Rx). La liaison peut être une liaison électrique, optique ou aérienne. Les normes de communication prévoient des tests normalisés de simulation de trafic sur les liaisons. Ces tests s'effectuent au moyen d'un appareil 4 (TEST-RNG) spécifique, raccordé à la place de l'émetteur 2. Cet appareil de test émet une séquence pseudo aléatoire PRBS sur la ligne de transmission. Cette séquence est généralement de très haut débit. Dans l'application au test, on peut également tester directement un dispositif (par exemple, le récepteur ou un récupérateur d'horloge de la liaison) électrique, optique, hertzien, opto-électrique ou électro-optique. Les séquences pseudo-aléatoires sont fixées, par exemple, par une norme ITQ 0.151.

La figure 2 illustre, par une vue très schématique et sous forme de blocs, un deuxième exemple d'application de l'invention. Il s'agit de brouiller ou coder une transmission, ou de moyenner les caractéristiques des signaux afin de masquer les données émises ou d'équilibrer le trafic sur une liaison.

La figure 2 représente un émetteur 2 (Tx) connecté à une liaison 1. L'émetteur 2 comprend un circuit numérique 21 ($\mu$Tx) de traitement de données D en vue de leur émission après modulation éventuelle (modulateur 22) sur une porteuse OL provenant d'un oscillateur local, et passage dans un amplificateur d'émission 23 (LNA). Un brouilleur ou codeur 24 est prévu en sortie du circuit 21 avant modulation par l'élément 22. Ce brouilleur (SCRAMB-RNG) a pour objet de modifier, à l'aide d'une séquence pseudo aléatoire, les caractéristiques des données émises.

L'invention s'applique également dans le cas d'une transmission optique. Par exemple, un brouilleur peut être intercalé en amont de la conversion électro-optique, l'oscillateur local étant une source lumineuse, par exemple, un laser.

Des générateurs pseudo aléatoires sont également utilisés dans des applications de code correcteur d'erreurs, de transmissions de type "accès multiple par répartition de code" (CDMA), de cryptographie, etc.

La figure 3 représente un exemple classique de générateur d'une séquence pseudo aléatoire (PRBS) du type de ceux utilisés dans les applications précitées. Un tel générateur est basé sur l'utilisation de registres à décalage bouclés sur eux-mêmes. Plusieurs bascules 30 (B1, Bi, Bn) sont associées en série, c'est-à-dire que la sortie Q de la bascule B1 est reliée à l'entrée de donnée D de la deuxième bascule et ainsi de suite jusqu'à ce que la sortie Q de l'avant dernière bascule soit reliée à l'entrée D de la nième bascules. La sortie de la dernière bascule Bn est rebouclée, par l'intermédiaire d'une porte de type OU-Exclusif 31, sur l'entrée D de la première bascule. La deuxième entrée de la porte 31 est reliée en sortie d'une bascule intermédiaire Bi de l'association en série.

Le nombre de bascules dépend de la puissance souhaitée pour la séquence pseudo aléatoire, c'est-à-dire le nombre de bits sur lequel la probabilité d'obtenir un 0 ou un 1 est respectée. Plus la séquence est longue, donc plus le nombre n de bascules est important, meilleur est l'aléa de la séquence PRBS générée. En fait, la longueur de la séquence est égale à $2^n-1$. Par exemple, en utilisant 7 bascules, on obtient une séquence de 127 bits.

Le choix de la position de la bascule intermédiaire Bi dans l'association en série est lié à l'obtention d'un polynôme irréductible de degré n et dépend donc du nombre d'étages. Les séquences de bits générées sont généralement dénommées "m-Sequences" et respectent une récurrence linéaire dont la caractéristique polynomiale est primitive. De telles séquences sont par exemple décrites dans l'ouvragé "Finite Fields For Computer Scientists And Engineers" de Robert J.Mc Eliece publié chez Kluwer Academic Publishers en 1995.

Un inconvénient des générateurs de signaux électriques PRBS actuels est lié aux applications haut débit, c'est-à-dire de plusieurs dizaines de gigabits/s. La réalisation de circuits logiques et notamment de bascules rapides requiert des technologies particulièrement coûteuses. En pratique, au delà de 10 à 20 gigabits/s, on doit utiliser des multiplexeurs pour mélanger des signaux déphasés entre eux selon une technique ETDM (Electrical Time Division Multiplexing), dont le nombre d'entrées (donc la complexité) est lié au facteur d'accélération souhaité. Cette solution requiert en outre de générer, en parallèle, tous les signaux déphasés.

Dans une réalisation optique, il n'existe aujourd'hui pas d'équipement permettant d'atteindre des débits supérieurs à 48 gigabits par seconde, sauf à avoir recours à des multiplexeurs de type OTDM (Optical Time Division Multiplexing) dont le nombre est lié au facteur d'accélération souhaité.

La présente invention vise à proposer une nouvelle technique de génération de trains de bits aléatoires qui permette d'atteindre des débits élevés. Selon un premier aspect, l'invention vise à réduire le nombre d'éléments électroniques utilisés pour la génération du flux. L'invention vise notamment à permettre une réduction du nombre de composants rapides d'un générateur à registres à décalage, ou le recours à un simple multiplexeur à deux entrées.

L'invention vise également à proposer une solution qui soit compatible avec une génération électronique et/ou optique.

Le document US-A-4 545 024 décrit un générateur de nombres aléatoires dans lequel un flux de bits de sortie retardé est combiné à un flux de bits d'entrée. Les deux flux ne sont pas identiques. La fréquence du flux de sortie est inférieure ou égale à celle du flux d'entrée. En outre, ce document exclut l'utilisation d'un flux d'entrée pseudo-aléatoire. De plus, le document WO 01/37441 décrit un générateur de nombres pseudo aléatoires.

Pour atteindre ces objets ainsi que d'autres, l'invention prévoit un procédé d'accélération d'un flux de bits d'entrée pseudo aléatoire, généré à une première fréquence d'horloge relativement basse, en un flux de bits de sortie identique à une deuxième fréquence d'horloge relativement élevée, consistant :

à prélever le flux de bits de sortie ;
à retarder le flux prélevé d'une valeur ($\tau$) prédéterminée ; et
à combiner le flux retardé avec le flux de bits d'entrée.

Selon un mode de mise en oeuvre de la présente invention, le retard $\tau$ est choisi pour respecter la relation suivante :

$$\tau = 2^{\ell}T_1 - T_0,$$

où $T_1$ représente la période d'horloge du flux de bits d'entrée, où $T_0$ représente la période de l'horloge du flux de bits de sortie, et où $\ell$ est un nombre entier fixant un paramètre de décimation.

Selon un mode de mise en oeuvre de la présente invention, le retard $\tau$ est choisi pour respecter la relation suivante :

$$\tau = (2k+1) * (2^n - 1) * T_0,$$

où k représente un entier quelconque, et où n représente le degré du polynôme irréductible de la séquence aléatoire.

Selon un mode de mise en oeuvre de la présente invention, les nombres k et $\ell$ respectent la relation suivante :

$$(2k+1) * (2^n - 1) + 1 = p2^{\ell},$$

où p est le facteur d'accélération souhaité.

L'invention prévoit également un circuit d'accélération d'un flux de bits initial généré à une première fréquence relativement basse, en un flux de bit identique accéléré à une deuxième fréquence relativement élevée, comportant un combineur dont une première entrée reçoit le flux de bits initial et dont une sortie fournit le flux accéléré, une deuxième entrée du combineur étant reliée par un élément retardateur à la sortie du combineur.

Selon un mode de réalisation de la présente invention, un élément de remise en forme à la fréquence élevée est prévu en sortie du combineur.

Selon un mode de réalisation de la présente invention, un élément déphaseur est en outre prévu entre le générateur de la séquence pseudo aléatoire d'origine et le combineur.

Selon un mode de réalisation de la présente invention, le flux de bits initial est obtenu par un générateur à bascules.

Selon un mode de réalisation de la présente invention, le circuit est réalisé par des moyens optiques et/ou électroniques.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1 à 3 qui ont été décrites précédemment sont destinées à exposer l'état de la technique et le problème posé ;
la figure 4 représente, de façon très schématique et sous forme de blocs, un mode de réalisation d'un dispositif d'accroissement de débit d'un flux aléatoire selon la présente invention ;
la figure 5 illustre le fonctionnement d'un dispositif d'augmentation de débit selon l'invention ; et
la figure 6 illustre, de façon très schématique et sous forme de blocs, un mode de réalisation d'un générateur haut débit selon l'invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, la réalisation pratique des circuits électroniques exploités par l'invention n'a pas été détaillée quand il s'agit de mettre en oeuvre des dispositifs en eux-mêmes connus. De plus, l'invention sera décrite par la suite en relation avec une application à des dispositifs électroniques mais elle s'applique également à des dispositifs optiques, électro-optiques, ou optoélectroniques.

Une caractéristique de la présente invention est de générer un flux de bits pseudo aléatoire à une première fréquence d'horloge inférieure à la fréquence d'horloge souhaitée, et de combiner ce flux initial avec le flux de sortie retardé d'une quantité choisie, pour obtenir en sortie un flux à la fréquence plus élevée.

Le retard choisi pour recombiner le flux de bits de sortie avec le flux de bits généré à bas débit est choisi pour correspondre à la longueur totale de la séquence visée ($2^n$-1) multipliée par la période de l'horloge à haut débit et par un entier impair quelconque. En d'autres termes, en notant $\tau$ le retard apporté par la ligne retardant le flux de bits sortant avant combinaison avec le flux de bits entrant, n le degré du polynôme irréductible correspondant à la séquence aléatoire visée, $T_0$ la période de l'horloge à haut débit et $T_1$ la période de l'horloge du bas débit entrant, le retard $\tau$ est choisi pour respecter la formule suivante :

$$\tau = (2k+1)*(2^n-1)*T_0,$$

où k représente un entier quelconque, et où $(2^n-1)$ correspond au nombre de bits de la séquence aléatoire.

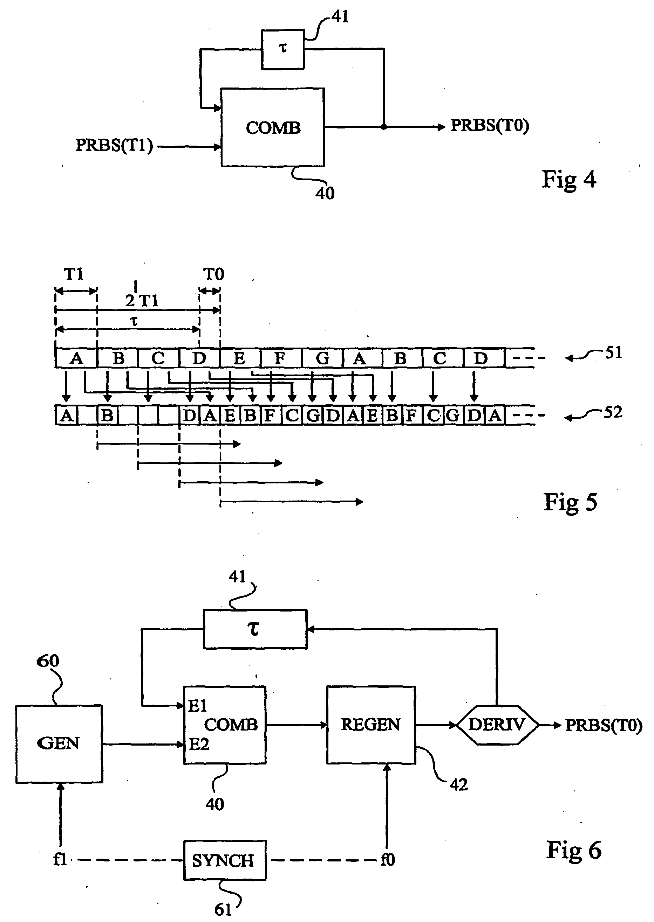

La figure 4 illustre, de façon très schématique et sous forme de blocs, un mode de réalisation d'un circuit accélérateur selon l'invention. Un tel circuit exploite en entrée un flux de bits aléatoire $PRBS(T_1)$ à une première fréquence relativement basse, et est chargé de fournir un flux de bits pseudo aléatoire $PRBS(T_0)$ à une fréquence relativement élevée. On désignera par la suite par p, le facteur d'accélération ($p = T_1/T_0$). Un combineur 40 (COMB) reçoit en entrée le flux basse fréquence et le flux de bits de sortie après qu'il ait traversé une ligne à retard 41 de valeur $\tau$.

La présente invention tire profit du fait qu'il est possible de générer un flux à un débit relativement bas et de combiner ce flux avec le même flux retardé d'une période adéquate pour obtenir un train de bits pseudo aléatoire de débit plus élevé. Ainsi, il est possible d'utiliser un générateur de débit inférieur, donc moins onéreux, pour obtenir le flux PRBS ($T_1$) initial.

Le seul élément qui selon l'invention doit fonctionner à haut débit est le combineur 40 (et les éléments en aval éventuels).

L'invention peut être mise en oeuvre par un circuit en portes logiques à la condition que le rapport cyclique des impulsions du train de bits d'entrée soit choisi de sorte que la durée d'un état haut soit inférieure ou égale à la durée d'un bit du flux de sortie, c'est-à-dire à la période $T_0$. En fait, si cette durée d'état haut est inférieure à la condition pré-citée, on peut générer une sortie de type RZ, c'est-à-dire avec retour à zéro. Si la durée (largeur) d'état haut est égale au temps de bit final, la sortie est de type NRZ, c'est-à-dire sans retour à zéro.

La figure 5 illustre le fonctionnement d'un accélérateur selon l'invention. Cette figure représente, sous forme de chronogrammes, un flux de bits initial 51 et un flux de bits final 52 après application du procédé d'accélération de l'invention. On suppose ici un flux initial A, B, C, D, E, F, et G de longueur $2^n-1 = 7$ bits et de polynôme irréductible $x^3 + x + 1$ de degré n = 3. Le retard apporté par la ligne 41 est choisi pour correspondre à $2^{\ell}T_1 - T_0$ avec $\ell = 2$.

Le paramètre $\ell$ est lié au facteur d'accélération (p) par la relation suivante : $(2k+1)*(2^n-1) + 1 = p2^{\ell}$, et fixe le paramètre de décimation ($2^{\ell}$) choisi. On pourra se référer à l'ouvrage de Robert J.Mc Eliece déjà mentionné pour le choix de ce paramètre.

On voit qu'à l'issue d'une durée correspondant au retard $\tau$, le flux de bits aléatoire 52 présent en sortie de l'accélérateur correspond à un flux de fréquence double par rapport à la fréquence du flux initial 51.

De plus, le flux est identique, c'est-à-dire que la séquence de sortie est égale à la séquence d'entrée. Par exemple, en supposant que la séquence d'entrée <ABCDEFG> est égale à <1110100>, on voit que la séquence de sortie <AEBFCGD> est bien égale à <1110100>.

L'exemple de la figure 5 a été pris de façon simplifiée pour un doublement de fréquence. On notera toutefois que le nombre p peut être choisi pour donner un flux de bits d'un multiple de période supérieur à deux par rapport au flux initial. La seule condition à respecter est que le retard $\tau$ corresponde à un multiple entier de la période $T_0$, c'est-à-dire à une valeur $2^{\ell}T_1-T_0$, pour obtenir une séquence de sortie identique à celle d'entrée (au débit près), et dont les impulsions à l'état haut sont de durée inférieure ou égale à $T_0$.

La figure 6 illustre un mode de réalisation d'un accélérateur selon l'invention, associé à un générateur de flux pseudo aléatoire.

Le générateur 60 est un générateur d'impulsions modulées à un débit relativement bas commandé par un signal d'horloge de fréquence f1. La sortie de ce générateur est envoyée sur une entrée E2 d'un combineur 40 (COMB) dont l'autre entrée reçoit la sortie de la ligne en retard 41 apportant un retard $\tau$ à un signal qu'elle prélève sur le flux $PRBS(T_0)$ de sortie. Ce flux $PRBS(T_0)$ peut être fourni en pratique par un circuit 42 de régénération (REGEN) chargé de mettre en forme, à la fréquence f0 > f1, la sortie du combineur 40. Bien entendu, les fréquences f1 et f0 sont synchronisées (par exemple, au moyen d'un circuit 61 (SYNCH)).

Selon un autre mode de réalisation, on utilise un multiplexeur à deux entrées en guise de combineur (40). Le signal d'entrée à bas débit $PRBS(T_1)$ est alors appliqué sur l'entrée de sélection du multiplexeur tandis que ses deux entrées de données reçoivent respectivement la sortie de la ligne à retard (41) et un niveau haut constant.

On notera qu'à la différence des techniques classiques ETDM ou OTDM qui utilisent des répliques retardées d'un signal d'entrée, l'invention réalise une boucle à recirculation dans laquelle le retard est appliqué à un signal prélevé en sortie.

En pratique, les entrées E1 et E2 du combineur doivent recevoir des signaux en phase. Par exemple, on prévoit un élément de type déphaseur (de préférence, ajustable) entre le générateur 60 (ou intégré à ce dernier) et le combineur 40 pour mettre en phase les signaux appliqués aux entrées E1 et E2.

La description qui précède a été faite en relation avec une réalisation au moyen de circuits électroniques. On notera toutefois qu'une réalisation complètement ou partiellement optique de l'invention est possible. Par exemple, on peut utiliser une source optique de quelques gigabits/s, voire quelques dizaine de gigabits/s, que l'on soumet à un accélérateur selon l'invention. Un tel accélérateur peut être obtenu en séparant le flux de bits initial par un séparateur, l'une des voies étant affectée d'un retard choisi comme pour la version électronique.

Bien entendu, la présente invention est susceptible de diverses variantes et modifications qui apparaîtront à l'homme de l'art. En particulier, la réalisation pratique d'une ligne à retard pour la mise en oeuvre de l'invention, que ce soit par des technologies électroniques ou optiques, est à la portée de l'homme du métier à partir des indications fonctionnelles données ci-dessus. Par exemple, on pourra faire appel à des techniques optiques et/ou électriques au sein du circuit accélérateur (modulateur optique commandé électriquement, photodiode associée à un laser, etc.). De plus, l'exploitation des flux à haut débit générés par l'invention est compatible avec toutes les applications classiques.

## Revendications

1. Procédé d'accélération d'un flux de bits d'entrée pseudo aléatoire ($PRBS(T_1)$) de longueur $2^n-1$ bits, générées à partir d'un polynôme irréductible de degré n à une première fréquence d'horloge (f1), en un flux de bits de sortie identique ($PRBS(T_0)$) à une deuxième fréquence d'horloge (f0) supérieure à la première fréquence d'horloge, le procédé comprenant les étapes suivantes : le flux de bits de sortie est prélevé; le flux prélevé est retardé d'une valeur ($\tau$) respectant la relation suivante :

$$\tau = 2^{\ell}T_1 - T_0,$$

où $T_1$ représente la période d'horloge du flux de bits d'entrée, où $T_0$ représente la période de l'horloge du flux de bit de sortie, et où $\ell$ est un nombre entier fixant un paramètre de décimation ;
le flux retardé est combiné avec le flux de bits d'entrée.

2. Procédé selon la revendication 1, dans lequel le retard $\tau$ est choisi pour respecter la relation suivante :

$$\tau = (2k+1) * (2^n-1) * T_0,$$

où k représente un entier quelconque, et où n représente le degré du polynôme irréductible de la séquence aléatoire.

3. Procédé selon la revendication 2, dans lequel les nombres k et t respectent la relation suivante :

$$(2k+1) * (2^n-1) + 1 = p2^{\ell},$$

où p est le facteur d'accélération souhaité.

4. Circuit d'accélération d'un flux de bits pseudo-aléatoire initial ($PRBS(T_1)$) de longueur $2^n-1$ généré à partir d'un polynôme irréductible de degré n à une première fréquence (f1), en un flux de bit identique ($PRBS(T_0)$) accéléré à une deuxième fréquence (f0) supérieure à la première fréquence d'horloge, le circuit comportant un combineur (40) dont une première entrée est adaptée à recevoir le flux de bits initial et dont une sortie est adaptée à fournir le flux accéléré, une deuxième entrée du combineur étant reliée par un élément retardateur (41) à la sortie du combineur, le retard $\tau$ apporté par l'élément retardateur respectant la relation suivante :

$$\tau = 2^{\ell}T_1 - T_0,$$

où $T_1$ représente la période d'horloge du flux de bits d'entrée, où $T_0$ représente la période de l'horloge du flux de bit de sortie, et où $\ell$ est un nombre entier fixant un paramètre de décimation.

5. Circuit selon la revendication 4, dans lequel un élément (42) de remise en forme à la fréquence élevée est prévu en sortie du combineur.

6. Circuit selon la revendication 5, dans lequel un élément déphaseur est en outre prévu entre le générateur de la séquence pseudo aléatoire d'origine et le combineur (42).

7. Circuit selon l'une quelconque des revendications 5 à 6, dans lequel le flux de bits initial est obtenu par un générateur à bascules.

8. Circuit selon l'une quelconque des revendications 5 à 7, réalisé par des moyens optiques et/ou électroniques.

9. Circuit selon l'une quelconque des revendications 4 à 8, dans lequel le retard appliqué par ledit élément retardateur (41) est choisi par la mise en oeuvre du procédé de l'une quelconque des revendications 2 à 4.

## Claims

1. A method for accelerating a pseudo-random input bit flow ($PRBS(T_1)$) having a length of $2^{n-1}$ bits, generated from a polynom of an irreducible degree n at a first clock frequency (f1), into an identical output bit flow (PRBS($T_0$)) at a second clock frequency (f0), greater than the first clock frequency, the method comprising the following steps:

the output bit flow is collected;
the collected flow is delayed by a predetermined value ($\tau$) respecting the following relation:

$$\tau \ = \ 2^{\ell}T_1 - T_0,$$

where $T_1$ represents the clock period of the input bit flow, $T_0$ represents the clock period of the output bit flow, and $\ell$ is an integer setting a decimation parameter;
the delayed flow is combined with the input bit flow.

2. The method of claim 1, wherein delay $\tau$ is selected to respect the following relation:

$$\tau \ = \ (2k+1) \ast (2^n - 1) \ast T_0,$$

where k represents any integer, and where n represents the degree of the irreducible polynomial of the random sequence.

3. The method of claim 2, wherein numbers k and $\ell$ respect the following relation:

$$(2k+1) \ast (2^n - 1) + 1 \ = \ p2^{\ell},$$

where p is the desired acceleration factor.

4. A circuit for accelerating an initial pseudo-random bit flow (PRBS($T_1$)) having a length of $2^{n-1}$ bits, generated from a polynom of an irreducible degree n at a first frequency (f1), into an identical accelerated bit flow (PRBS($T_0$)) at a second frequency (f0) greater than the first clock frequency, the circuit comprising a combiner (40) having a first input adapted to receiving the initial bit flow and having an output adapted to providing the accelerated flow, a second input of the combiner being connected by a delay element (41) to the combiner output, the delay $\tau$ of the delaying element respecting the following relation:

$$\tau \ = \ 2^{\ell}T_1 - T_0,$$

where $T_1$ represents the clock period of the input bit flow, $T_0$ represents the clock period of the output bit flow, and $\ell$ is an integer setting a decimation parameter.

5. The circuit of claim 4, wherein a reshaping element (42) at the high frequency is provided at the combiner output.

6. The circuit of claim 5, wherein a phase-shifting element is further provided between the generator of the original pseudo-random bit sequence and the combiner (42).

7. The circuit of any of claims 5 to 6, wherein the initial bit flow is obtained by a flip-flop generator.

8. The circuit of any of claims 5 to 7, formed by optical and/or electronic means.

9. The circuit of any of claims 4 to 8, wherein the delay applied by said delay element (41) is selected by implementation of the method of any of claims 2 to 4.

**Patentansprüche**

1. Ein Verfahren zum Beschleunigen eines pseudo-zufälligen Eingangs-Bit-Stroms (PRBS($T_1$)), der eine Länge von $2^{n-1}$ Bits besitzt, erzeugt aus einem Polynom mit einem unreduzierbaren Grad n mit einer ersten Taktfrequenz (f1) in einen identischen Ausgabe-Bit-Strom (PRBS($T_0$)) mit einer zweiten Taktfrequenz (f0), die größer ist als die erste Taktfrequenz, wobei das Verfahren die folgenden Schritte aufweist:

der Ausgabe-Bit-Strom wird gesammelt;
der gesammelte Strom wird um einen vorherbestimmten Wert ($\tau$) verzögert unter Berücksichtigung der folgenden Beziehung:

$$\tau \ = \ 2^{\ell}T_1 - T_0,$$

wobei $T_1$ die Taktperiode von dem Eingangs-Bit-Strom repräsentiert, $T_0$ die Taktperiode von dem Ausgangs-Bit-Strom repräsentiert und die $\ell$ eine ganze Zahl ist, die einen Dezimationsparameter festlegt;
der verzögerte Strom mit dem Eingangs-Bit-Strom kombiniert wird.

2. Verfahren nach Anspruch 1, wobei die Verzögerung $\tau$ entsprechend der folgenden Beziehung ausgewählt wird:

$$\tau \ = \ (2k+1) \ast (2^n - 1) \ast T_0,$$

wobei k irgendeine ganze Zahl repräsentiert, und wobei n den Grad des unreduzierbaren Polynoms von der Zufallssequenz repräsentiert.

3. Verfahren nach Anspruch 2, wobei die Zahlen k und $\ell$ die folgende Beziehung erfüllen:

$$(2k+1) * (2^n-1) + 1 = p2^\ell,$$

wobei p der gewünschte Beschleunigungsfaktor ist.

4. Eine Schaltung zum Beschleunigen eines initialen pseudo-zufälligen Bit-Stroms ($PRBS(T_1)$), der eine Länge von $2^{n-1}$ Bits besitzt, erzeugt von einem Polynom mit einem unreduzierbaren Grad n mit einer ersten Frequenz (f1), in einen identischen beschleunigten Bit-Strom ($PRBS(T_0)$) mit einer zweiten Frequenz (f0), die größer ist als die erste Taktfrequenz, wobei die Schaltung einen Kombinierer (40) aufweist, der einen ersten Eingang besitzt, der angepasst ist zum Empfangen des initialen Bit-Stroms und einen Ausgang besitzt, der angepasst ist zum Vorsehen des beschleunigten Bit-Stroms, ein zweiter Eingang von dem Kombinierer mit einem Verzögerungselement (41) mit dem Kombiniererausgang verbunden ist, wobei die Verzögerung $\tau$ von dem Verzögerungselement entsprechend der folgenden Beziehung ist:

$$\tau = 2^\ell T_1 - T_0,$$

wobei $T_1$ die Taktperiode von dem Eingangs-Bit-Strom repräsentiert, $T_0$ die Taktperiode von dem Ausgangs-Bit-Strom repräsentiert und $\ell$ eine ganze Zahl ist, die einen Dezimationsparameter einstellt.

5. Schaltung nach Anspruch 4, wobei ein Neuformungselement (42) bei der hohen Frequenz an dem Kombiniererausgang vorgesehen ist.

6. Schaltung nach Anspruch 5, wobei ein Phasenschiebungselement ferner vorgesehen ist zwischen dem Generator von der originalen pseudo-zufälligen Sequenz und dem Kombinierer (42).

7. Schaltung nach irgendeinem der Ansprüche 5 bis 6, wobei der initiale Bit-Strom durch einen Flip-Flop-Generator erlangt wird.

8. Schaltung nach irgendeinem der Ansprüche 5 bis 7, die durch optische und/oder elektronische Mittel gebildet ist.

9. Schaltung nach irgendeinem der Ansprüche 4 bis 8, wobei die durch das Verzögerungselement (41) angelegte Verzögerung durch die Implementierung von einem Verfahren nach irgendeinem der Ansprüche 2 bis 4 ausgewählt wird.

**Fig 1**

**Fig 2**

**Fig 3**

Fig 4

Fig 5

Fig 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4545024 A
- WO 0137441 A